# FASCICULE DE BREVET EUROPEEN

(11) **EP 1 818 985 B1**
(45) Date de publication et mention de la délivrance du brevet: **02.12.2009**
(21) Numéro de dépôt: 07101676.0
(22) Date de dépôt: 02.02.2007
(51) Int. Cl.: H01L 23/522, H01L 21/768

(54) **Procédé de réalisation de structures d'interconnexions**
Verfahren zur Herstellung von Verbindungs-Strukturen
Manufacturing method for interconnection structures

(30) Priorité: 08.02.2006 FR 0650443
(43) Date de publication de la demande: 15.08.2007
(73) Titulaire: COMMISSARIAT A L'ENERGIE ATOMIQUE, 75015 Paris (FR)
(72) Inventeur: LOUIS, Didier, 38500, COUBLEVIE (FR)
(74) Mandataire: Poulin, Gérard

(56) Documents cités:
- FR-A- 2 641 896
- US-A- 5 750 415
- US-A1- 2004 137 728

## Description

### DOMAINE TECHNIQUE ET ART ANTÉRIEUR

L'invention concerne le domaine des circuits intégrés, et de la réalisation de structures d'interconnexion, mettant en oeuvre des éléments conducteurs tels que le cuivre ou l'aluminium, ces éléments conducteurs étant séparés de zones diélectriques.

L'amélioration des performances des circuits intégrés passe par l'évolution des matériaux intégrés en présence. Si la réalisation du transistor (partie chaude de l'intégration) depuis 30 ans continue de conserver au maximum des matériaux de base comme le silicium polyristallin dopé et un diélectrique de grille en oxyde de silicium, toute la partie des interconnections a subit une rupture au niveau du choix des matériaux. Pour des considérations de résistivité et donc de propagation du signal électronique, le cuivre a remplacé l'aluminium. De même, pour des considérations de capacité parasites entre les bandes d'interconnexion métallique, le matériau diélectrique, pendant longtemps à base d'oxyde de silicium déposé par plasma, a été remplacé par des matériaux de constante diélectrique plus faible communément appelés matériaux « Low-k » (k représentant la constante diélectrique).

Le cuivre reste le choix unique du matériau conducteur pour les circuits très amonts. Mais le matériau diélectrique évolue, le paramètre important étant la diminution de sa constante diélectrique pour diminuer les phénomènes liés aux capacités parasites créées entre les bandes conductrices.

On est donc passé d'un matériau de type oxyde de silicium déposé par des techniques de plasma (PECVD) à des matériaux, toujours à base de silicium, mais dont la nature se rapproche de plus en plus de structures organiques (introduction de carbone dans la structure monomère - structures -(Si-OC)--)).

En plus du rapprochement de structures de plus en plus organiques, l'introduction de porosités apparaît comme étant une des solutions pour réduire la constante diélectrique de ces matériaux isolants, le but ultime étant d'intégrer de l'air de constante diélectrique égale à 1.

De telles structures sont déjà connues de l'art antérieur : on peut se reporter par exemple au document WO 2004/001842. Un tel document décrit l'utilisation d'un matériau organique, qui est ensuite éliminé par dégradation thermique par divers procédés physico-chimiques (attaque de type plasma ou chimique humide).

Pour réaliser ces cavités entre les lignes, différentes approches existent comme l'utilisation d'un matériau sacrificiel pendant l'intégration qui est ensuite extrait au moyen de divers procédés physico-chimiques (attaque de type plasma, ou attaque chimique humide).

Une première possibilité consiste en l'utilisation d'un matériau diélectrique , déposé entre des bandes d'interconnexions et ensuite éliminé par une dégradation thermique, assistée ou non par un rayonnement Ultra - violet ou électronique.

Une deuxième possibilité, consiste en la réalisation d'un dépôt non - conforme, qui ne remplit pas la totalité de la cavité pendant l'étape de dépôt, créant ainsi un volume d'air.

La difficulté des approches connues est de trouver un matériau sacrificiel capable de supporter les contraintes de l'intégration (budget thermique, stress mécanique, etc...) .

Une autre limitation de ces techniques se situe au niveau de la globalité du procédé : l'ensemble du matériau sacrificiel est éliminé, quelle que soit la technique utilisée.

Pour répondre à ce problème, les cavités peuvent être définies par lithographie et gravure, ce qui, dans ce cas précis, permet d'adresser des zones bien particulières et voulues (création d'air gap en zone denses uniquement par exemple). Un problème (et non des moindres) est que le rajout de ces étapes est très coûteux d'un point de vue industriel.

Enfin, et quelle que soit la technique utilisée, la création d'un bon « air gap» doit de préférence répondre aux critères suivants :
- pas de résidus laissés dans l'air gap (courant de fuites entre lignes, champ de claquage entre lignes).
- pas d'attaque du cuivre et des couches barrières entourant toute la ligne de cuivre, ceci pour éviter les phénomènes d'electromigration ou d'électrocorrosion.

### EXPOSÉ DE L'INVENTION

L'invention propose un nouveau procédé pour la réalisation de telles structures, dans lequel on forme, sur un substrat :
- une première couche comportant une ou plusieurs zones conductrices et une ou plusieurs zones isolantes en un matériau organique, par exemple de nature polysaccharide ou protéinique,
- on recouvre cette première couche par une couche poreuse,
- on utilise des enzymes et/ou des protéines pour consommer au moins en partie le matériau organique à travers la couche poreuse et pour l'éliminer.

Le matériau organique sacrificiel est donc recouvert d'une membrane poreuse à travers laquelle peuvent passer des enzymes qui viennent ainsi digérer ce même matériau organique.

Selon l'invention, on créé des cavités et des structures poreuses, stade ultime de l'évolution de la constante diélectrique, en utilisant un matériau sacrificiel, éliminé non plus par des méthodes d'intégration telles que définies dans l'art antérieur, mais en utilisant une digestion ou une biodégradation enzymatique.

L'enzyme ou la protéine consomme donc un composé, tel que par exemple un polymère, pour le rendre biodégradable.

L'enzyme présente l'avantage d'être très sélective en ce qui concerne la digestion des matériaux.

Le matériau organique sacrificiel est, au cours de l'intégration, recouvert d'une membrane poreuse, par exemple de type purement organique, à travers laquelle pourront passer les enzymes et ainsi venir « digérer » le matériau organique. Les enzymes sont des protéines et agissent, comme tout catalyseur chimique, en faible quantité.

Une couche isolante peut être réalisée sur la couche poreuse, après élimination d'au moins une partie du matériau organique. Des plots ou des bandes ou des lignes métalliques peuvent être formés dans cette couche isolante.

Un tel procédé peut comporter en outre la réalisation d'une deuxième couche comportant une ou plusieurs zones conductrices et une ou plusieurs zones isolantes en un matériau organique, et le recouvrement de cette deuxième couche par une deuxième couche poreuse. Au moins une partie du matériau organique de la deuxième couche peut être consommée et éliminée, à travers la deuxième couche poreuse, à l'aide d'enzymes et/ou de protéines.

Un des avantages d'un procédé selon l'invention est de pouvoir déposer le matériau à température ambiante, tout en restant compatible avec les contraintes de l'intégration microélectronique.

Un autre avantage du procédé selon l'invention est que la réaction enzymatique peut s'engager en milieu aqueux ou non.

Le procédé selon l'invention présente encore d'autres avantages :
- on peut gérer la fin de la réaction de digestion enzymatique par utilisation, par exemple, de rayonnement ultra-violet ou par chauffage thermique,
- les résidus à base de carbone de la réaction enzymatique ne sont pas tueurs pour les dispositifs,
- la réaction chimique de digestion enzymatique ne concerne que le matériau sacrificiel, sans impact sur les autres matériaux environnants. Il n'y a donc pas de risque de décollement, d'attaque entre les différentes couches de l'empilement, pas de modifications des dimensions, pas d'attaque du matériau conducteur (cuivre).

De préférence, la digestion enzymatique a lieu à des températures voisines de 20°C, par exemple comprises entre 15 et 50°C.

Un procédé selon l'invention permet d'obtenir une structure de connexion comportant :
- une première couche comportant elle-même, une ou plusieurs zones conductrices, une ou plusieurs zones isolantes en un matériau organique, et une ou plusieurs cavités,
- une première couche poreuse recouvrant la première couche.

Une telle structure de connexion peut en outre comporter une couche isolante sur la couche poreuse.

Des plots ou des bandes ou des lignes métalliques peuvent être réalisées dans la couche isolante.

Une telle structure peut en outre comporter une deuxième couche comportant elle-même une ou plusieurs zones conductrices, et une ou plusieurs zones isolantes en un matériau organique, la deuxième couche pouvant comporter en outre une ou plusieurs cavités.

L'invention permet également d'obtenir une structure de connexion comportant :
- une première couche comportant elle-même une ou plusieurs zones conductrices, et des cavités séparant ces zones conductrices,
- une première couche poreuse et une première couche diélectrique recouvrant la première couche.

### BRÈVE DESCRIPTION DES DESSINS

- La figure 1 représente un dispositif obtenu par un procédé selon l'invention,
- les figures 2A - 2G représentent des étapes d'un procédé selon l'invention,
- les figures 3, 4 et 5 représentent des variantes de dispositifs selon l'invention.

### EXPOSÉ DÉTAILLÉ DE MODES DE RÉALISATION PARTICULIERS

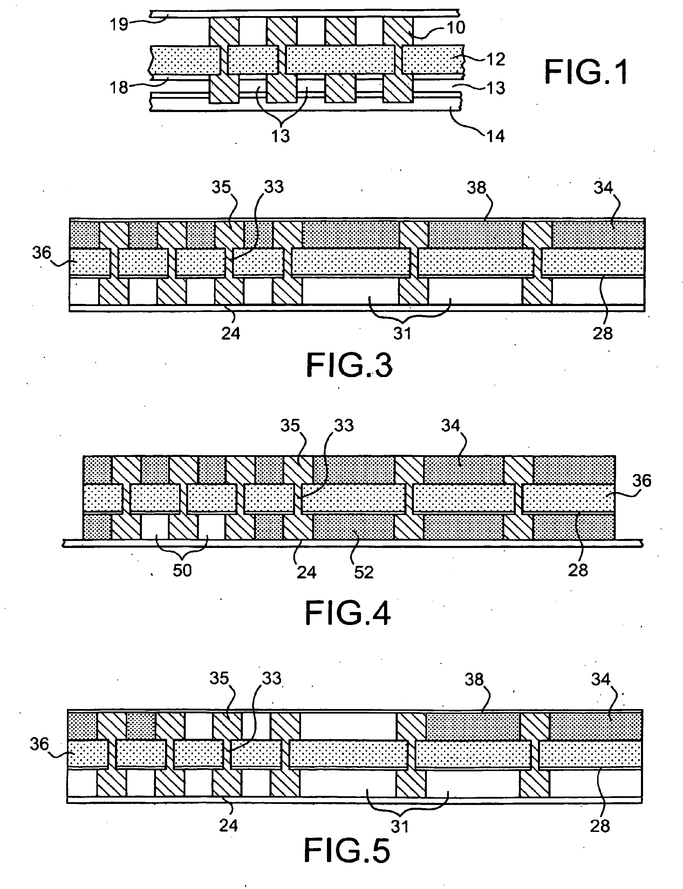

La figure 1 représente un dispositif obtenu par un procédé selon l'invention : des éléments conducteurs 10, par exemple en cuivre, traversent une membrane diélectrique 12, reliant ainsi cette membrane et un substrat 14. Une couche, comportant une alternance de cavités 13 séparant les éléments conducteurs 10 est disposée entre la membrane diélectrique 12 et le substrat 14. Les références 18 et 19 désignent des couches poreuses, comme décrit ci-dessous. En variante, la couche 19 pourrait être supprimée.

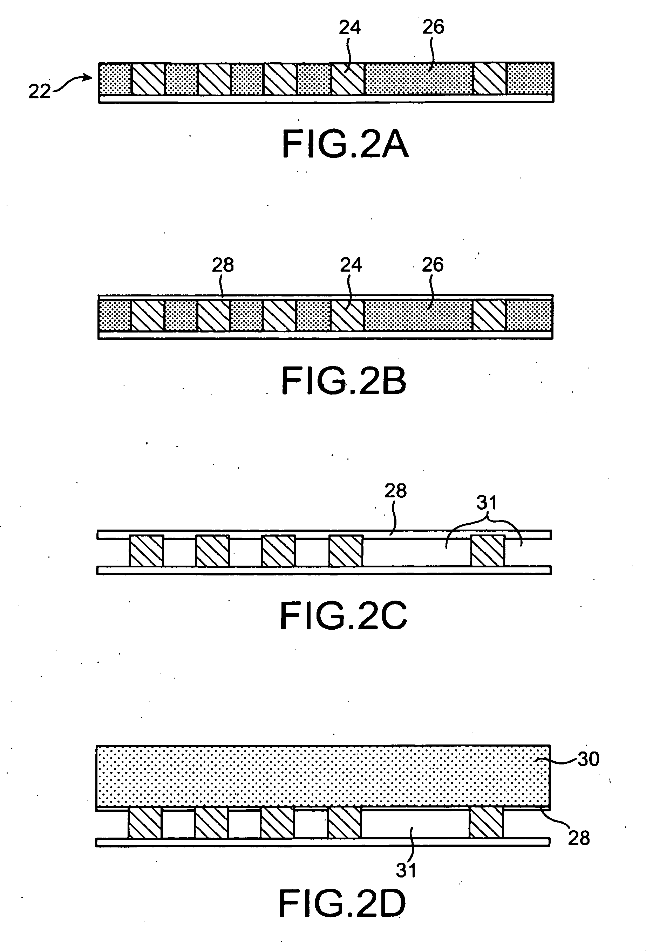

Les figures 2A - 2G représentent des étapes d'un procédé selon l'invention.

Dans une première étape, une première couche 22, comportant une ou plusieurs zones conductrices 24 et une ou plusieurs zones isolantes 26 en un matériau sacrificiel organique, est réalisée (figure 2A).

Le matériau sacrificiel organique peut être déposé par tournette entre les plots ou les bandes de métal 24. Il est par exemple de nature polysaccharide (sucre) ou protéinique. Un matériau de type polysaccharide pourra être dissous dans un solvant approprié de manière à maîtriser sa viscosité pour l'étaler à la tournette.

Le matériau sacrificiel pourra avoir une composition chimique du type de celui de l'amidon :

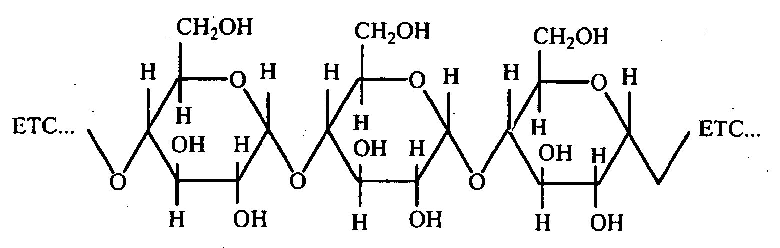

Les dérivés de la cellulose et du glycogène peuvent également être utilisés, ainsi que tous les polysaccharides en général.

Une membrane poreuse 28 est ensuite formée, par exemple à la tournette ou par technique CVD, sur cette première couche 22 (figure 2B). Cette membrane peut être de type purement organique (un dérivé de phtalate d'Ethylène par exemple), avec des tailles de pores compatibles avec l'intégration microélectronique (par exemple comprises entre 2 nm et 10 nm).

Des enzymes ou des protéines peuvent ensuite venir digérer le matériau organique 26 à travers la couche poreuse 28 (figure 2C). Les plaques peuvent être trempées ou mises dans un bain par exemple aqueux contenant les enzymes ou les protéines. Le bain peut être mat ou alimenté en continu pour accélérer la réaction. La durée de la réaction dépend de la quantité de matière à digérer, de la température (si on chauffe, la réaction s'accélère), elle est par exemple comprise entre quelques heures et 1 jour. Une réaction d'hydrolyse enzymatique consomme le matériau organique, laissant libre des cavités 31 sous la membrane poreuse 28. Dans l'exemple de la figure 2C, tout le matériau organique est consommé, ne laissant que des cavités séparant les zones conductrices 24. Comme décrit ci-dessous, une consommation partielle du matériau organique de cette couche est également possible.

La catalyse enzymatique peut être décomposée en 3 étapes:
- formation d'un complexe Enzyme - Substrat (composé biodégradable) entre l'enzyme et son substrat,
- transfert de protons et d'électrons faisant apparaître des composés de transition,
- libération des produits de la réaction.

Les protéines, molécules dont la structure tridimensionnelle détermine la fonction biologique, sont fragiles, et leur structure peut être altérée et leur fonction annihilée ou transformée si la température du milieu réactionnel dans lequel elles se trouvent est trop élevée. Cette propriété peut être utile pour mettre fin, par chauffage, à la digestion enzymatique.

Après cette digestion, on peut réaliser, sur la couche poreuse 28, une couche 30, par exemple en matériau diélectrique tel que SiO₂ (figure 2D).

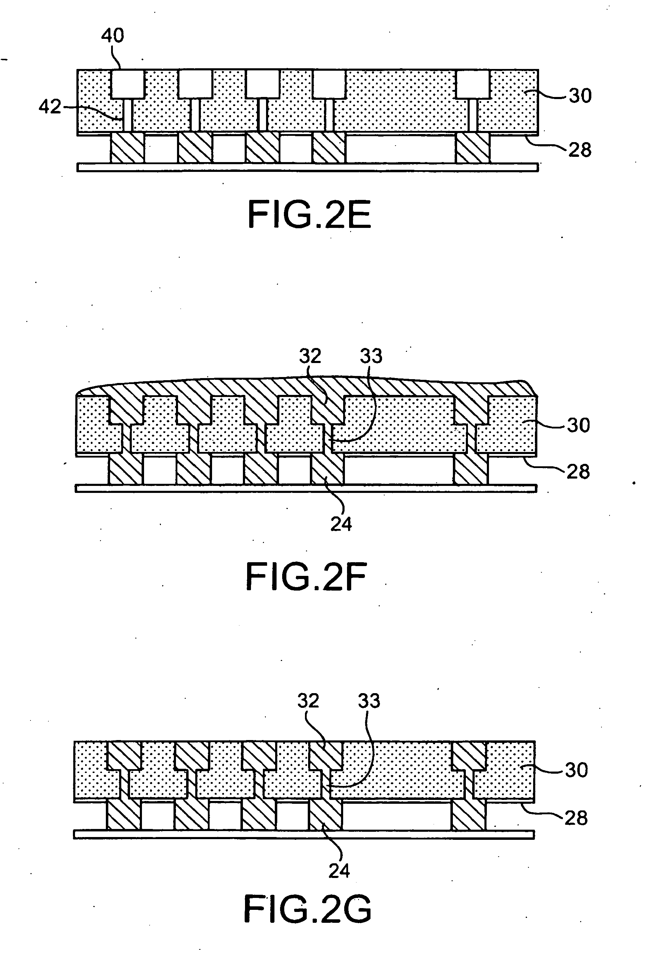

Cette couche peut elle-même être gravée (figure 2E) afin de définir un deuxième niveau de lignes 40, et un niveau intermédiaire de trous 42, ou vias.

Un dépôt de matériau conducteur 32 (figure 2F) permet de combler ces zones gravées pour établir les niveaux conducteurs 33, 35 souhaités. Ce dépôt peut subir une étape de polissage (figure 2G).

Selon une variante, illustrée en figure 3, un deuxième niveau 34 de matériau organique est réalisé sur un niveau intermédiaire 36 de matériau diélectrique, de type SiO₂ ou SiOC. Cette deuxième couche organique sacrificielle 34 peut avoir une composition choisie parmi celles déjà indiquées ci-dessus pour la couche 26. Cette couche 34 et la couche diélectrique 36 sont gravées. Un dépôt métallique permet de former, dans cette couche, des plots 35 conducteurs qui peuvent être reliés aux plots ou aux bandes 24 par des lignes 33 réalisées dans la couche 36.

Il peut ensuite être procédé au dépôt d'une nouvelle membrane poreuse 38, par exemple de même nature que la première membrane 28 ou de composition choisie parmi celles déjà indiquées ci-dessus.

Des enzymes ou des protéines peuvent ensuite venir digérer tout ou partie du matériau organique 34 à travers la couche poreuse 38. Une deuxième réaction d'hydrolyse enzymatique consomme donc le matériau organique 34, au moins partiellement. Les conditions de réaction peuvent par exemple être déduites de celles déjà données ci-dessus.

Ce procédé peut être répété sur un nombre quelconque d'étages, une couche diélectrique d'un étage, déposée sur la membrane, poreuse ayant servi à l'attaque du matériau organique de l'étage inférieur.

On obtient alors une structure intégrée de type damascène, comportant une couche de matériau permanent entre des plots de cuivre éventuellement reliés par des lignes conductrices.

Il est également possible d'avoir une structure étagée pour laquelle certains étages ne sont pas digérés ou gravés par l'un des procédés décrits ci-dessus, au moins une des couches organiques d'un des autres étages étant éliminée, au moins partiellement, par l'un de ces procédés selon l'invention.

Selon encore une autre variante, illustrée en figure 4, un niveau de matériau organique, par exemple le premier, n'est consommé que localement, par exemple grâce à l'utilisation d'un masque. On peut ainsi former des zones d'air localisées dans un niveau contenant, par ailleurs, un matériau 52, de type organique ou minéral. Un deuxième niveau 34 de matériau organique peut, là encore, être réalisé sur un niveau intermédiaire 36 de matériau diélectrique, de type SiO₂ ou SiOC, ce deuxième niveau pouvant avoir une composition choisie parmi celles déjà indiquées ci-dessus pour la couche 26. Cette couche 34 et la couche diélectrique 36 sont gravées. Un dépôt métallique permet de former des plots 35 conducteurs qui peuvent être reliés aux plots ou aux bandes 24 par des lignes 33 réalisées dans la couche 36. La couche 34 peut ensuite être digérée, totalement ou partiellement, comme la première couche 26 (figure 2A) ou 52 (figure 4).

Cette autre variante permet de laisser subsister de la matière dans un ou plusieurs niveaux organiques (sur la figure 4 : dans le premier niveau 52), ce qui renforce la solidité mécanique de l'ensemble.

La figure 5 représente une structure obtenue selon l'invention, comportant une première couche dans laquelle tout le matériau organique a été consommé, ne laissant que des cavités 31 séparant les plots conducteurs 24, et une couche organique supérieure 34, qui a été partiellement consommée par une digestion enzymatique à travers une membrane 38. Si aucun étage supplémentaire n'est ajouté, la couche 38 peut être éliminée. Il pourrait même y avoir digestion enzymatique sans couche 38 , la digestion est alors directe. La même remarque s'applique pour les structures des figures 2A et 2B. Cependant, dans le contexte d'une intégration complète, dans laquelle l'intégration se termine par un niveau de plots, cette couche 28 permet d'assurer un maintien mécanique de la structure globale.

## Revendications

1. Procédé de réalisation de structures d'interconnexions, comportant :
a) la formation, sur un substrat, d'une première couche comportant, une ou plusieurs zones conductrices (24) et une ou plusieurs zones isolantes en un matériau organique (26),
b) le recouvrement de cette première couche par une couche poreuse (28),
et **caracterisé par**
c) la consommation et l'élimination d'au moins une partie du matériau organique, à travers la couche poreuse, à l'aide d'enzymes et/ou de protéines.

2. Procédé selon la revendication 1, la couche poreuse étant de type purement organique.

3. Procédé selon la revendication 1, la couche poreuse étant un dérivé de phtalate d'éthylène.

4. Procédé selon l'une des revendications 1 à 3, dans lequel, pour mettre fin à la réaction de consommation du matériau organique, on dirige un rayonnement ultra-violet vers le substrat ou on chauffe le substrat.

5. Procédé selon l'une des revendications 1 à 4, le matériau organique étant déposé par tournette entre les zones conductrices (24).

6. Procédé selon l'une des revendications 1 à 5, le matériau organique étant de nature polysaccharide ou protéinique.

7. Procédé selon l'une des revendications 1 à 6, comportant en outre une étape de réalisation d'une couche isolante (36) sur la couche poreuse (28), après élimination d'au moins une partie du matériau organique, et une étape de formation de plots ou de bandes ou de lignes métalliques (33) dans cette couche isolante.

8. Procédé selon la revendication 7, comportant en outre la réalisation d'une deuxième couche comportant une ou plusieurs zones conductrices (35) et une ou plusieurs zones isolantes en un matériau organique (34), et le recouvrement de cette deuxième couche par une deuxième couche poreuse (38).

9. Procédé selon la revendication 8, comportant en outre la consommation et l'élimination d'au moins une partie du matériau organique (34) de la deuxième couche, à travers la deuxième couche poreuse (38), à l'aide d'enzymes et/ou de protéines.

## Claims

1. Process for manufacturing interconnection structures, including:
a) the formation, on a substrate, of a first layer comprising one or several conducting zones (24) and one or several insulating zones made of an organic material (26),
b) coverage of this first layer by a porous layer (28),
and **characterized by**:
c) consumption and elimination of at least part of the organic material, through the porous layer, using enzymes and / or proteins.

2. Process set forth in claim 1, the porous layer being of the purely organic type.

3. Process set forth in claim 1, the porous layer being a derivative of Ethylene phthalate.

4. Process set forth in one of claims 1 to 3, in which ultra-violet radiation is directed towards the substrate, or the substrate is heated, so as to terminate the organic material consumption reaction.

5. Process set forth in one of claims 1 to 4, the organic material being deposited by spin coating between the conducting zones (24).

6. Process set forth in one of claims 1 to 5, the organic material being a polysaccharide or a protein.

7. Process set forth in one of claims 1 to 6, also including a step for manufacturing an insulating layer (36) on the porous layer (28) after eliminating at least part of the organic material, and a step for the formation of pads or strips or metallic lines (33) in this insulating layer.

8. Process set forth in claim 7, also comprising manufacturing of a second layer including one or several conducting zones (35) and one or several insulating zones made of an organic material (34), and covering of this second layer by a second porous layer (38).

9. Process set forth in claim 8, also comprising consumption and elimination of at least part of the organic material (34) in the second layer, through the second porous layer (38), using enzymes and/or proteins.

## Patentansprüche

1. Verfahren zur Herstellung von Verbindungsstrukturen, umfassend:
a) die Bildung einer ersten Schicht auf einem Substrat, die eine oder mehrere leitende Zonen (24) und eine oder mehrere isolierende Zonen aus einem organischen Material (26) umfasst,
b) das Überziehen dieser ersten Schicht mit einer porösen Schicht (28),
und **gekennzeichnet durch**
c) den Verbrauch und die Entfernung wenigstens eines Teils des organischen Materials, **durch** die poröse Schicht hindurch, mit Hilfe von Enzymen und/oder Proteinen.

2. Verfahren nach Anspruch 1, wobei die poröse Schicht eine rein organische Schicht ist.

3. Verfahren nach Anspruch 1, wobei die poröse Schicht ein Derivat von Ethylenphthalat ist.

4. Verfahren nach einem der Ansprüche 1 bis 3, in welchem man eine Ultraviolettstrahlung auf das Substrat richtet oder das Substrat erhitzt, um die Verbrauchsreaktion des organischen Materials zu beenden.

5. Verfahren nach einem der Ansprüche 1 bis 4, wobei das organische Material mit einem Schleuderapparat zwischen den leitenden Zonen (24) aufgebracht wird.

6. Verfahren nach einem der Ansprüche 1 bis 5, wobei das organische Material von polysaccharid- oder proteinartiger Beschaffenheit ist.

7. Verfahren nach einem der Ansprüche 1 bis 6, außerdem umfassend einen Schritt der Herstellung einer isolierenden Schicht (36) auf der porösen Schicht (28) nach der Entfernung wenigstens eines Teils des organischen Materials und einen Schritt der Bildung von metallischen Kontakten oder Bahnen oder Leitungen (33) in dieser isolierenden Schicht.

8. Verfahren nach Anspruch 7, außerdem umfassend die Herstellung einer zweiten Schicht, umfassend eine oder mehrere leitende Zonen (35) und eine oder mehrere isolierende Zonen aus einem organischen Material (34), und das Überziehen dieser zweiten Schicht mit einer zweiten porösen Schicht (38).

9. Verfahren nach Anspruch 8, außerdem umfassend den Verbrauch und die Entfernung wenigstens eines Teils des organischen Materials (34) der zweiten Schicht, durch die zweite poröse Schicht (38) hindurch, mit Hilfe von Enzymen und/oder Proteinen.
